# EUROPEAN PATENT APPLICATION

(11) **EP 4 447 110 A2**
(43) Date of publication of application: **16.10.2024**
(21) Application number: 24158891.2
(22) Date of filing: 21.02.2024
(51) Int. Cl.: H01L 25/065, H01L 21/60, H01L 25/18, H01L 21/98

(54) **SEMICONDUCTOR PACKAGE**

(30) Priority: 11.04.2023 KR 20230047619
(71) Applicant: Samsung Electronics Co., Ltd., Suwon-si, Gyeonggi-do 16677 (KR)
(72) Inventor: JUN, Joonho, 16677 Suwon-si (KR); SOHN, Kyomin, 16677 Suwon-si (KR); KIM, Duksung, 16677 Suwon-si (KR); JO, Byoungkon, 16677 Suwon-si (KR); CHOI, Jangseok, 16677 Suwon-si (KR)
(74) Representative: Marks & Clerk LLP

(57) **Abstract**

A semiconductor package according to an example embodiment of the present disclosure includes: a package substrate; and first to third memory dies disposed on the package substrate and sequentially stacked in a first direction, perpendicular to an upper surface of the package substrate, and the first memory die and the second memory die are attached to each other without a bump, and the second memory die and the third memory die are attached to each other by a plurality of bumps

## Description

### BACKGROUND

The present disclosure relates to a semiconductor package.

A semiconductor package includes two or more memory dies, and the two or more memory dies may be mounted on a package substrate in stacked form. The two or more memory dies include a plurality of pads, and the plurality of pads may be bonded to each other by a plurality of bumps. However, when the memory dies are stacked by bonding the plurality of pads to each other using the plurality of bumps, there is bound to be a limit to reducing the height of the stacked memory dies, which may lead to a problem in improving an integration of the semiconductor package.

### SUMMARY

An aspect of the present disclosure is to provide a semiconductor package having improved integration by forming one memory layer with two or more memory dies bonded without bumps and stacking a plurality of memory layers using a plurality of bumps.

According to an aspect of the present disclosure, a semiconductor package includes: a package substrate; a buffer die mounted on the package substrate; and a plurality of memory layers stacked on the buffer die, wherein each of the plurality of memory layers includes a pair of memory dies, each memory die of each pair of memory dies includes a semiconductor substrate, a plurality of semiconductor elements formed on the semiconductor substrate, a plurality of via structures penetrating through the semiconductor substrate, a plurality of lower pads formed on a lower surface of the semiconductor substrate and connected to the plurality of via structures, and a plurality of upper pads formed on an upper surface of an insulating layer disposed on the semiconductor substrate and connected to the plurality of via structures, and the plurality of upper pads included in one memory die of each pair of memory dies are directly attached to the plurality of upper pads included in another memory die of the pair of memory dies.

The plurality of upper pads included in each memory die may be substantially flush with the upper surface of the insulating layer of the memory die.

The plurality of upper pads of each semiconductor layer may be of copper, CU, and the plurality of upper pads included in one memory die of the each pair of memory dies may be directly attached to the plurality of upper pads included in another memory die of the pair of memory dies by a Cu-Cu bond.

According to an aspect of the present disclosure, a semiconductor package includes: a package substrate; and first to third memory dies disposed on the package substrate and sequentially stacked in a first direction, perpendicular to an upper surface of the package substrate, wherein each of the first to third memory dies includes a semiconductor substrate and a plurality of semiconductor elements formed on an upper surface of the semiconductor substrate, and in the first direction, a gap between an upper surface of the semiconductor substrate included in the first memory die and an upper surface of the semiconductor substrate included in the second memory die is different from a gap between the upper surface of the semiconductor substrate included in the second memory die and an upper surface of the semiconductor substrate included in the third memory die.

According to an aspect of the present disclosure, a semiconductor package includes: a package substrate; and first to third memory dies disposed on the package substrate and sequentially stacked in a first direction, perpendicular to an upper surface of the package substrate, wherein the first memory die and the second memory die are attached to each other without a bump, and the second memory die and the third memory die are attached to each other by a plurality of bumps.

According to an example embodiment of the present disclosure, each of a plurality of memory layers included in a semiconductor package and stacked with each other may include two or more memory dies bonded to each other in a manner in which pads are directly attached without bumps. Accordingly, the number of memory dies included in semiconductor packages of the same size may be increased, thereby improving the integration of the semiconductor package, and providing a greater storage capacity using one single semiconductor package.

Advantages and effects of the present application are not limited to the foregoing content and may be more easily understood in the process of describing a specific example embodiment of the present disclosure.

At least some of the above and other features of the invention are set out in the claims.

### BRIEF DESCRIPTION OF DRAWINGS

The above and other aspects, features, and advantages of the present disclosure will be more clearly understood from the following detailed description, taken in conjunction with the accompanying drawings, in which:
FIG. 1 is a view schematically illustrating a system including a semiconductor package according to an example embodiment of the present disclosure;
FIG. 2 is a view schematically illustrating a semiconductor package according to an example embodiment of the present disclosure;
FIG. 3 is a block diagram schematically illustrating a system including a semiconductor package according to an example embodiment of the present disclosure;
FIGS. 4 to 6 are views schematically illustrating a semiconductor package according to example embodiments of the present disclosure;
FIGS. 7 and 8 are views schematically illustrating a memory layer included in a semiconductor package according to an example embodiment of the present disclosure;
FIG. 9 is a block diagram schematically illustrating a memory die included in a semiconductor package according to an example embodiment of the present disclosure;
FIGS. 10A and 10B are views schematically illustrating a memory die included in a semiconductor package according to an example embodiment of the present disclosure;
FIGS. 11 to 16 are views illustrating a process of manufacturing a memory die included in a semiconductor package according to an example embodiment of the present disclosure;
FIGS. 17 to 23 are views illustrating a process of manufacturing a memory layer included in a semiconductor package according to an example embodiment of the present disclosure;
FIGS. 24 to 26 are views schematically illustrating a semiconductor package according to example embodiments of the present disclosure; and
FIGS. 27 to 30 are views illustrating a process of manufacturing a memory layer included in a semiconductor package according to an example embodiment of the present disclosure.

### DETAILED DESCRIPTION

Hereinafter, example embodiments of the present disclosure will be described with reference to the accompanying drawings. Like reference characters refer to like elements throughout.

It will be understood that when an element is referred to as being "connected" or "coupled" to or "on" another element, it can be directly connected or coupled to or on the other element or intervening elements may be present. In contrast, when an element is referred to as being "directly connected" or "directly coupled" to another element, or as "contacting" or "in contact with" another element (or using any form of the word "contact"), there are no intervening elements present at the point of contact.

Terms such as "same," "equal," "planar," or "coplanar," as used herein, encompass near identicality including variations that may occur, for example, due to manufacturing processes. The term "substantially" may be used herein to emphasize this meaning, unless the context or other statements indicate otherwise.

It will be understood that, although the terms first, second, third etc. may be used herein to describe various elements, components, regions, layers and/or sections, these elements, components, regions, layers and/or sections should not be limited by these terms. Unless the context indicates otherwise, these terms are only used to distinguish one element, component, region, layer or section from another element, component, region, layer or section, for example as a naming convention. Thus, a first element, component, region, layer or section discussed below in one section of the specification could be termed a second element, component, region, layer or section in another section of the specification or in the claims without departing from the teachings of the present invention. In addition, in certain cases, even if a term is not described using "first," "second," etc., in the specification, it may still be referred to as "first" or "second" in a claim in order to distinguish different claimed elements from each other.

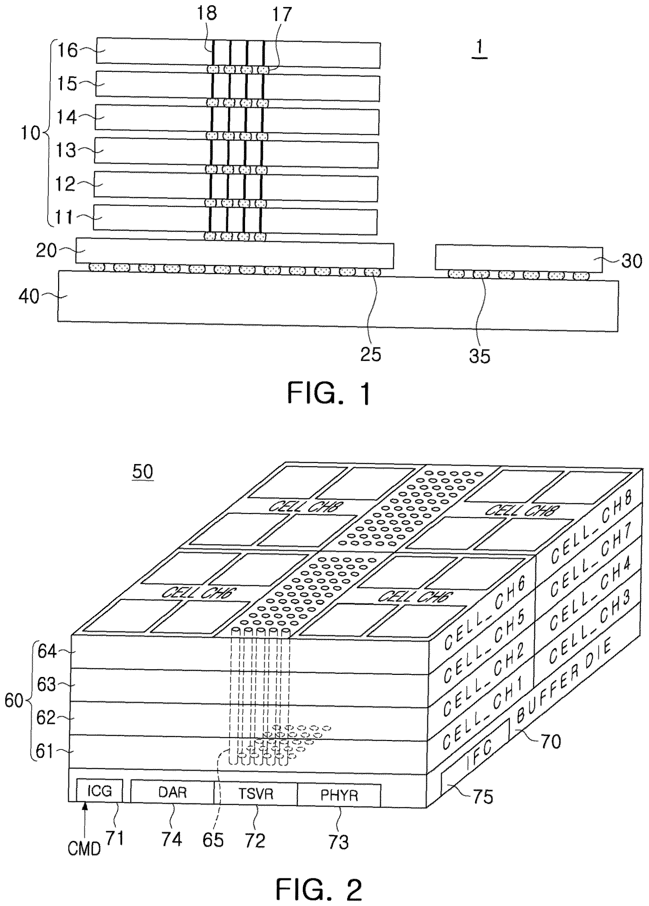

FIG. 1 is a view schematically illustrating a system including a semiconductor package according to an example embodiment of the present disclosure.

Referring to FIG. 1, a semiconductor package 1 according to an example embodiment of the present disclosure may include a plurality of memory layers 10 (i.e., memory layers 1 1 to 16), a buffer die 20, a controller 30, and a package substrate 40. In this example embodiment of the present disclosure, each of the plurality of memory layers 10 may have a structure in which a pair or more memory dies are stacked. Each of the plurality of memory dies may include memory cells for storing data and peripheral circuits for controlling the memory cells.

The plurality of memory layers 10 may be stacked on the buffer die 20 in a direction perpendicular to an upper surface of the package substrate 40 (e.g., a vertical direction). The plurality of memory layers 10 may be electrically connected to each other through a plurality of bumps 17. The plurality of bumps 17 may be disposed between pads formed on one surface of each of the plurality of memory layers 10 to physically and electrically connect a pair of memory layers 10 adjacent to each other.

A semiconductor die included in each of the plurality of memory layers 10 includes an element region and a wiring region, and elements providing a semiconductor substrate, memory cells, and peripheral circuits may be disposed in the element region. Wiring patterns connected to the memory cells and the peripheral circuits may be disposed in the wiring region. A plurality of via structures 18 included in the semiconductor die may each be a through silicon via (TSV) extending from the wiring region and penetrating through the semiconductor substrate. For example, each of the plurality of memory layers 10 may include a plurality of via structures 18, and each of the plurality of via structures 18 may extend between pads provided on upper and/or lower surfaces of each of the plurality of memory layers 10.

As described above, each of the plurality of memory layers 10 includes two or more memory dies stacked on each other, and the two or more memory dies may be connected to each other without a bump. For example, when each of the plurality of memory layers 10 includes a first memory die and a second memory die stacked on each other, pads of the first memory die and pads of the second memory die may be directly attached without the bump by a Cu-Cu bonding method. In this case, by connecting the pads of the first memory die and the pads of the second memory die, through silicon vias (TSV) of the first memory die may be connected to through silicon vias (TSV) of the second memory die. In this way, in each of the plurality of memory layers 10, the through silicon vias (TSV) included in the two or more memory dies may be connected to each other.

The buffer die 20 and the controller 30 may be mounted on an upper surface of the package substrate 40. The controller 30 may be a device configured to control a plurality of memory dies included in the plurality of memory layers 10, such as a central processing unit (CPU), a graphics processing unit (GPU), a system-on-chip (SoC), an application-specific integrated circuit (ASIC), and a memory controller. The controller 30 may transmit control signals for controlling each of the plurality of memory dies, and data signals for storing in at least some of the plurality of memory dies to the buffer die 20.

The buffer die 20 may transmit or receive signals to or from the controller 30, and may buffer the signals received from the controller 30 and transmit the buffered signals to at least one of the plurality of memory dies stacked thereon. However, according to example embodiments, the semiconductor package 1 may include only the buffer die 20 and the plurality of memory layers 10 stacked on the package substrate 40, and the number of memory layers 10 may vary depending on storage capacity to be provided to the semiconductor package 1.

FIG. 2 is a view schematically illustrating a semiconductor package according to an example embodiment of the present disclosure.

A semiconductor package 50 according to an embodiment illustrated in FIG. 2 may be a high bandwidth memory (HBM) type memory device having an increased bandwidth by including a plurality of channels having interfaces independent of each other. Referring to FIG. 2, the semiconductor package 50 may include a buffer die 70 and a memory layer 60 stacked on each other. The memory layer 60 may be stacked on the buffer die 70 and may include first to fourth memory dies 61 to 64. While FIG. 2 shows first to fourth memory dies 61 to 64, this is for purposes of illustration, and the number of memory dies included in the memory layer 60 may vary according to example embodiments.

Each of the first to fourth memory dies 61 to 64 included in the memory layer 60 may include one or more channels. In the example embodiment illustrated in FIG. 2, each of the memory dies 61 to 64 may include two channels, and one memory layer 60 may include eight channels CH1 to CH8. For example, a first memory die 61 may include a first channel CH1 and a third channel CH3, a second memory die 62 may include a second channel CH2 and a fourth channel CH4, a third memory die 63 may include a fifth channel CH5 and a seventh channel CH7, and a fourth memory die 64 may include a sixth channel CH8 and an eighth channel CH8.

The buffer die 70 may communicate with external hosts such as a memory controller, an application processor, and a central processing unit, and may receive a command signal, an address signal, and a data signal from external hosts. The buffer die 70 may provide the received command signal, the received address signal, and the received data signal to the memory dies 61 to 64. The buffer die 70 may be mounted on the package substrate included in the semiconductor package 50, and may transmit or receive signals to or from the external hosts through bumps and wiring patterns in the package substrate. Because the buffer die 70 buffers the command signal, the address signal, and the data signal, the external hosts may transmit or receive signals from or to the memory dies 61 to 64 while driving only a load of the buffer die 70.

The buffer die 70 and the plurality of memory dies 61 to 64 may be electrically connected to each other through a plurality of via structures 65. For example, each of the plurality of via structures 65 may be the through silicon via (TSV) penetrating through a silicon substrate.

The plurality of via structures 65 may be disposed to correspond to the plurality of channels CH1 to CH8. The plurality of via structures 65 may be arranged to penetrate through the first to fourth memory dies 61 to 64, and each of the first to fourth memory dies 61 to 64 may include an input/output circuit connected to the plurality of via structures 65. For example, in an operation mode in which data input/output is performed independently for each channel, only one input/output circuit of the first to fourth memory dies 61 to 64 may be activated for each of the plurality of via structures 65.

Referring to FIG. 2, the buffer die 70 may include an internal command generator (ICG) 71, a via region (TSVR) 72, a physical (PHY) region (PHYR) 73, a direct access (DA) region (DAR) 74, and an interface circuit (IFC) 75. The internal command generator 71 may generate an internal command using a command signal CMD received from an external host.

The via region 72 may be a region in which the plurality of via structures 65 for communicating with the plurality of memory dies 61 to 64 are formed. On the other hand, the physical region 73 may be a region in which an input/output circuit for communicating with the external host is disposed. For example, a signal received from the external host may be transmitted to the via region 72 through the physical region 73 and may be transmitted to at least one of the plurality of memory dies 61 to 64 through the plurality of via structures 65.

The direct access (DA) region 74 may communicate directly with an external test device through pads exposed to the outside of the semiconductor package 50 in a test mode for the semiconductor package 50. Signals provided from the test device may be provided to the plurality of memory dies 61 to 64 through the direct access (DA) region 74 and the via region 72.

The interface circuit 75 may provide an address signal and a data signal provided from the external host to at least one target memory die among the first to fourth memory dies 61 to 64 and may output a data signal output from the target memory die to the external host. Furthermore, the interface circuit 75 may provide a determination signal related to a test provided from the target memory die to an external device.

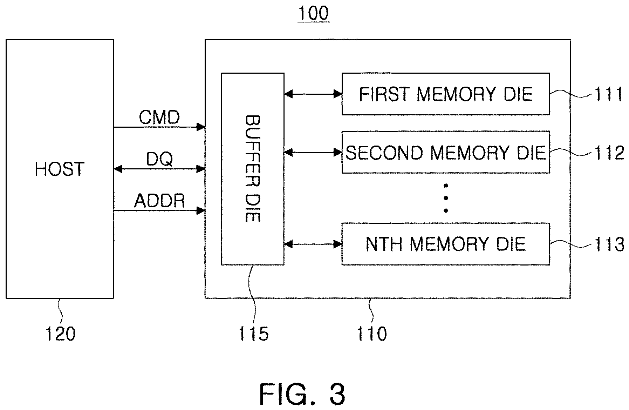

FIG. 3 is a block diagram schematically illustrating a system including a semiconductor package according to an example embodiment of the present disclosure.

Referring to FIG. 3, a system 100 according to an example embodiment of the present disclosure may include a semiconductor package 110 and a host 120. The semiconductor package 110 may include a plurality of memory dies 111 to 113 and a buffer die 115. The buffer die 115 may be mounted on the package substrate, and the plurality of memory dies 111 to 113 may be stacked on the buffer die 115. According to an example embodiment, the host 120 may be mounted on the package substrate such as the buffer die 115.

The host 120 may provide a command signal CMD and an address signal ADDR required for an operation of the semiconductor package 110, to the semiconductor package 110. As described above with reference to FIG. 2, the buffer die 115 may buffer the command signal CMD and the address signal ADDR and transmit the buffered signals to at least one of the plurality of memory dies 111 to 113, and each of the plurality of memory dies 111 to 113 may perform control operations such as reading, writing, erasing, and refreshing in response to the command signal CMD and the address signal ADDR received through the buffer die 115. The host 120 may receive a data signal DQ output as a result of the control operations of each of the plurality of memory dies 111 to 113 from the semiconductor package 110 or may transmit a data signal DQ including data to be stored, to the semiconductor package 110.

The plurality of memory dies 111 to 113 may be stacked on the buffer die 115, and some of the plurality of memory dies 111 to 113 may form one memory layer. The memory layer may refer to a structure in which two or more memory dies are connected without a bump. For example, the first memory die 111 may include a plurality of upper pads exposed to an upper surface of an insulating layer disposed on the semiconductor substrate, and similarly, the second memory die 112 may also include a plurality of upper pads exposed to the upper surface of the insulating layer. In an example embodiment, the upper pads of the first memory die 111 may contact the upper pads of the second memory die 112. In this example embodiment of the present disclosure, the upper pads of the first memory die 111 and the upper pads of the second memory die 112 may be directly bonded to each other without the bump by a Cu-Cu bonding method, thus forming a memory layer.

In the example embodiment, since the upper pads of the first memory die 111 and the upper pads of the second memory die 112 are directly bonded to each other, at least a portion of the upper surface of the insulating layer of the first memory die 111 may be in contact with at least a portion of the upper surface of the insulating layer of the second memory die 112. Accordingly, when the same number of memory dies 111 to 113 are stacked, the height of the memory dies 111 to 113 may be lowered, thereby improving the integration of the semiconductor package 110.

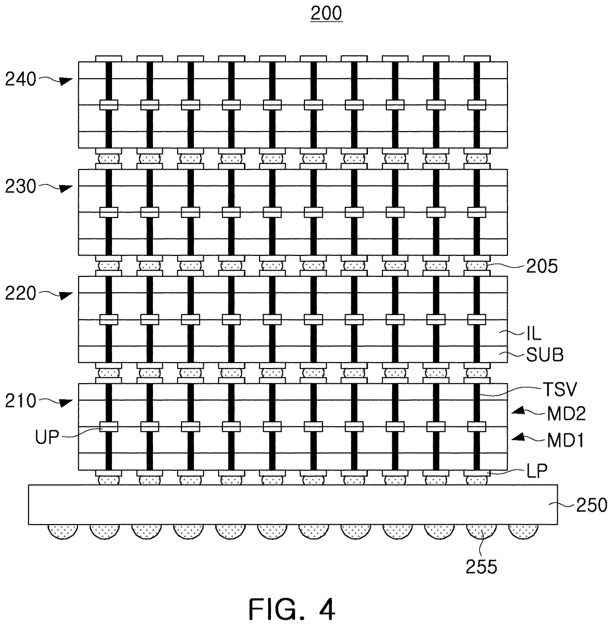

FIGS. 4 to 6 are views schematically illustrating a semiconductor package according to example embodiments of the present disclosure.

FIGS. 4 to 6 are simplified views illustrating a cross section of a region in which a plurality of via structures TSV are disposed in each of semiconductor packages 200, 200A, and 200B, respectively, according to example embodiments of the present disclosure. First, referring to FIG. 4, a semiconductor package 200 according to an example embodiment of the present disclosure may include a plurality of memory layers 210 to 240 and a buffer die 250. In example embodiments, a plurality of bumps 255 may be provided on a lower surface of the buffer die 250. The plurality of memory layers 210 to 240 may be stacked on the buffer die 250, and first to fourth memory layers 210 to 240 may be stacked on the buffer die 250 in this example embodiment illustrated in FIG. 4.

In an example embodiment illustrated in FIG. 4, each of the first to fourth memory layers 210 to 240 may have a structure in which a first memory die MD1 and a second memory die MD2 are stacked on each other. When the first memory layer 210 is described as an example, the second memory die MD2 may be disposed on the first memory die MD1 in the first memory layer 210. For example, the second memory die MD2 in the first memory layer 210 may contact the first memory die MD1 in the first memory layer 210. Likewise, in each of the second to fourth memory layers 220 to 240, the second memory die MD2 may be disposed on the first memory die MD1, and may contact the first memory die MD1.

Each of the first memory die MD1 and the second memory die MD2 may include a semiconductor substrate SUB and an insulating layer IL disposed on the semiconductor substrate SUB. For example, a plurality of semiconductor elements may be formed on the semiconductor substrate SUB, and the plurality of semiconductor elements may be connected by wiring patterns formed in the insulating layer IL to provide a circuit. The plurality of semiconductor elements and the wiring patterns may provide memory cells for storing data, peripheral circuits for driving the memory cells and performing control operations such as reading, writing, erasing, and refreshing, and input/output circuits for exchanging signals with the buffer die 250.

Each of the first memory die MD1 and the second memory die MD2 may include a plurality of upper pads UP exposed to the upper surface of the insulating layer IL and a plurality of lower pads LP exposed to the outside from a lower surface of the semiconductor substrate SUB. At least one of the plurality of upper pads UP and the plurality of lower pads LP may be a dummy pad that is not used for an input/output of a signal or a power supply voltage. In an example embodiment, the number of the plurality of upper pads UP may be identical to the number of the plurality of lower pads LP.

The upper surface of the insulating layer IL may be defined as a surface on which the plurality of upper pads UP are formed, and the lower surface of the insulating layer IL may be defined as a surface in contact with the upper surface of the semiconductor substrate SUB. Meanwhile, the lower surface of the semiconductor substrate SUB may be defined as a surface on which the plurality of lower pads LP are formed. In this example embodiment illustrated in FIG. 4, the plurality of upper pads UP are disposed in a space formed in the insulating layer IL, and upper surfaces of the plurality of upper pads UP may form a coplanar surface with the upper surface of the insulating layer IL. On the other hand, the plurality of lower pads LP may be disposed on the lower surface of the semiconductor substrate SUB. For example, the plurality of lower pads LP may contact the lower surface of the semiconductor substrate SUB.

As illustrated in FIG. 4, the plurality of memory layers 210 to 240 may be attached to each other by a plurality of bumps 205 and may be electrically connected to each other. For example, the lower pads LP of the second memory die MD2 included in the first memory layer 210 may be attached to the lower pads LP of the first memory die MD1 included in the second memory layer 220 by the plurality of bumps.

On the other hand, in each of the plurality of memory layers 210 to 240, the upper pads UP of the first memory die MD1 may be directly attached to the upper pads UP of the second memory die MD2 without the bump. For example, the upper pads UP of the first memory die MD1 may contact the upper pads UP of the second memory die MD2. Referring to the first memory layer 210, a plurality of upper pads UP exposed on an upper surface of an insulating layer IL of the first memory die MD1 may be directly attached to a plurality of upper pads UP exposed to an upper surface of an insulating layer IL of the second memory die MD2 without the bump.

Accordingly, a gap between the upper surface of the semiconductor substrate SUB included in the first memory die MD1 and the upper surface of the semiconductor substrate SUB included in the second memory die MD2 in the first memory layer 210 may be different from a gap between the upper surface of the semiconductor substrate SUB included in the second memory die MD2 of the first memory layer 210 and the upper surface of the semiconductor substrate SUB included in the first memory die MD1 of the second memory layer 220. This may be because the first memory die MD1 and the second memory die MD2 are attached to each other without the bump in one memory layer, and the first memory die MD1 and the second memory die MD2 are attached by the plurality of bumps 205 between different memory layers.

In an example embodiment illustrated in FIG. 4, in each of the plurality of memory layers 210 to 240, a plurality of semiconductor elements may be disposed between the upper surface of the semiconductor substrate SUB of the first memory die MD1 and the upper surface of the semiconductor substrate SUB of the second memory die MD2. On the other hand, the plurality of semiconductor elements may not be disposed between the upper surface of the semiconductor substrate SUB of the second memory die MD2 included in the first memory layer 210 and the upper surface of the semiconductor substrate SUB of the first memory die MD1 included in the second memory layer 220.

In an example embodiment illustrated in FIG. 4, the semiconductor package 200 may include eight memory dies. When all eight memory dies are stacked and bonded by the plurality of bumps 205, the number of the plurality of bumps 205 may increase as compared to the example embodiment described in FIG. 4, and accordingly, a height of the semiconductor package 200 may increase. For example, in this example embodiment of the present disclosure, the first memory die MD1 and the second memory die MD2 may be directly attached without the bump to form each of the plurality of memory layers 210 to 240 first, and the plurality of bumps 205 may be used only in stacking the plurality of memory layers 210 to 240, thereby improving the degree of integration of the semiconductor package 200 and improving storage capacity.

In an example embodiment, a process of directly attaching the first memory die MD1 and the second memory die MD2 without the bump may be performed at a wafer level. Before advancing to a dicing process of separating the memory dies, a process of attaching a first wafer and a second wafer in which the memory dies are formed may be performed, and then, a memory layer to which the first memory die MD1 and the second memory die MD2 are attached may be manufactured by performing the dicing process. On the other hand, a process of stacking the plurality of memory layers 210 to 240 using the plurality of bumps 205 may be performed at a chip level rather than the wafer level.

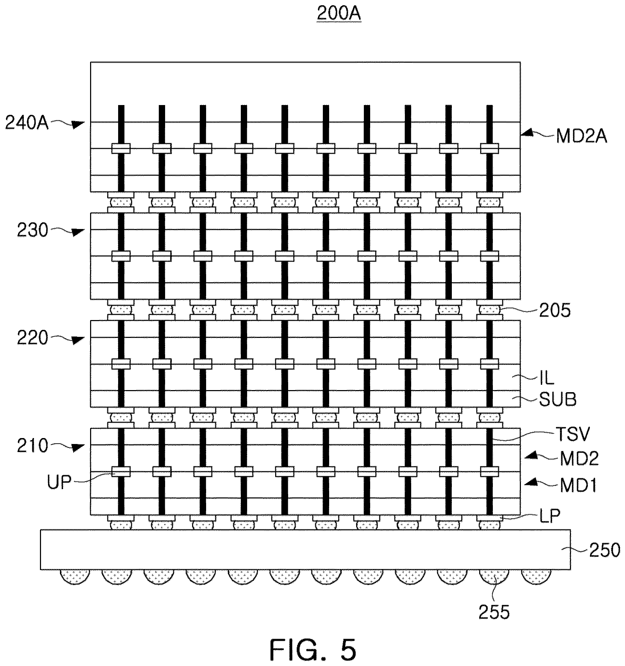

Next, referring to FIG. 5, a semiconductor package 200A according to an example embodiment of the present disclosure may include a plurality of memory layers 210 to 240A (e.g., first to fourth memory layers 210, 220, 230, and 240A) and a buffer die 250. Similar to the example embodiment described with reference to FIG. 4, the plurality of memory layers 210 to 240A may be stacked on the buffer die 250.

In this example embodiment illustrated in FIG. 5, a fourth memory layer 240A, which is a memory layer disposed at an uppermost end in a stacking direction, may have a different structure from other first to third memory layers 210 to 230. In each of the first to third memory layers 210 to 230, the first memory die MD1 and the second memory die MD2 may have the same structure. Referring to the first memory layer 210 as an example, each of the first memory die MD1 and the second memory die MD2 may include a semiconductor substrate SUB and an insulating layer IL disposed on the semiconductor substrate SUB. Furthermore, the semiconductor substrate SUB of the first memory die MD1 may have the same thickness as the semiconductor substrate SUB of the second memory die MD2.

On the other hand, in the fourth memory layer 240A, a semiconductor substrate SUB of a second memory die MD2A may have a thickness greater than that of a semiconductor substrate SUB of the first memory die MD1. For example, a first wafer including the first memory die MD1 and a second wafer including the second memory die MD2A may be bonded to each other at the wafer level in order to manufacture the fourth memory layer 240A. For the fourth memory layer 240A, after bonding the first wafer and the second wafer, a process of removing a portion of the semiconductor substrate SUB from the second wafer and forming the plurality of lower pads LP on the semiconductor substrate SUB may not be performed.

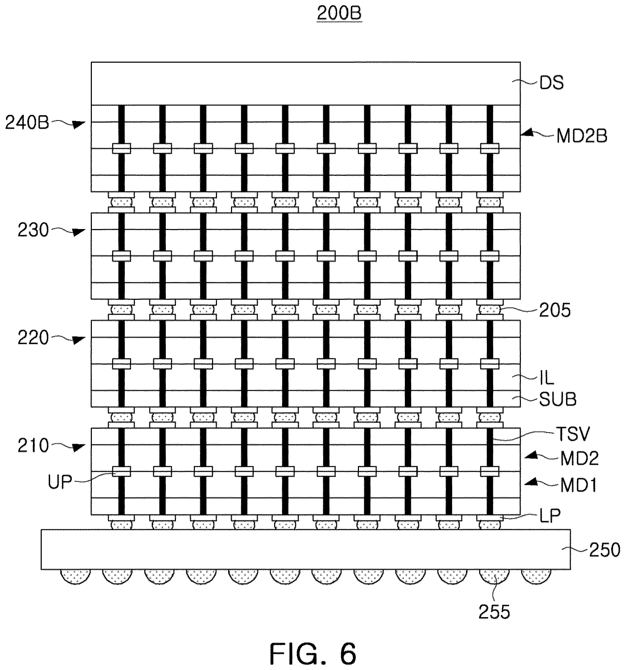

Referring to FIG. 6, a semiconductor package 200B according to an example embodiment of the present disclosure may include a plurality of memory layers 210 to 240B (e.g., first to fourth memory layers 210, 220, 230, and 240B) and a buffer die 250. Similar to the example embodiment described with reference to FIG. 4, the plurality of memory layers 210 to 240B may be stacked on the buffer die 250.

In an example embodiment illustrated in FIG. 6, the fourth memory layer 240B which is a memory layer disposed at an uppermost end in the stacking direction, may have a different structure from other first to third memory layers 210 to 230. In each of the first to third memory layers 210 to 230, the first memory die MD1 and the second memory die MD2 may have the same structure. In each of the first to third memory layers 210 to 230, the first memory die MD1 and the second memory die MD2 may include a semiconductor substrate SUB and an insulating layer IL disposed on the semiconductor substrate SUB. Furthermore, a plurality of lower pads LP may be formed on each of the semiconductor substrate SUB of the first memory die MD1 and the semiconductor substrate SUB of the second memory die MD2.

Meanwhile, in the fourth memory layer 240B, the plurality of lower pads LP may not be formed on the semiconductor substrate SUB of a second memory die MD2B. Because the second memory die MD2B is a memory die disposed at the uppermost end in the stacking direction, unlike the second memory die MD2 included in the other memory layers 210 to 230, the second memory die MD2B does not need to be connected to a plurality of bumps 205. As illustrated in FIG. 6, a dummy silicon substrate DS may be attached on a semiconductor substrate SUB included in the second memory die MD2B. For example, the dummy silicon substrate DS may contact a lower surface of the semiconductor substrate SUB included in the second memory die MD2B of the fourth memory layer 240B.

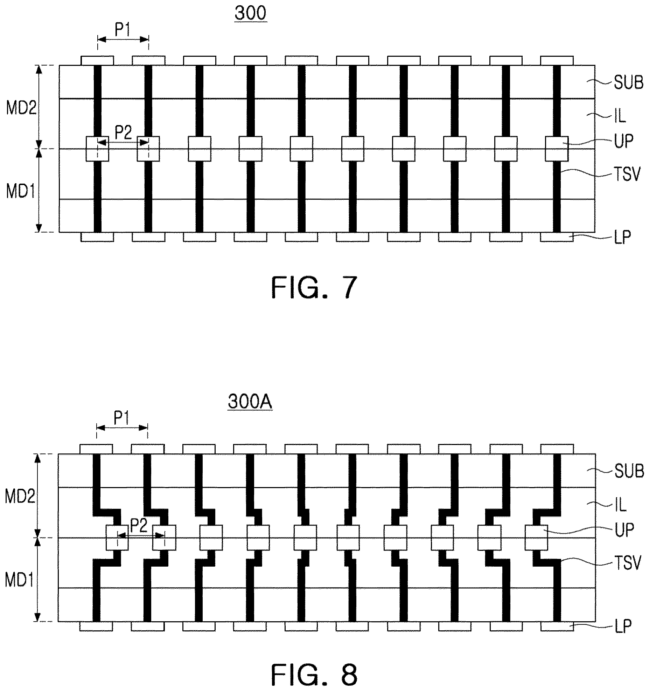

FIGS. 7 and 8 are views schematically illustrating a memory layer included in a semiconductor package according to an example embodiment of the present disclosure. The example memory layers of FIGS. 7 and 8 may correspond to any of the memory layers of FIGS. 4-6, including the first to third memory layers 210 to 230 or fourth memory layers 240, 240A, and 240B.

First, referring to FIG. 7, a memory layer 300 according to an example embodiment of the present disclosure may include a first memory die MD1 and a second memory die MD2. Each of the first memory die MD1 and the second memory die MD2 includes a semiconductor substrate SUB and an insulating layer IL, and a plurality of memory cells and elements providing peripheral circuits for controlling the plurality of memory cells may be formed on the semiconductor substrate SUB. A plurality of wiring patterns may be formed of a conductive material such as metal in the insulating layer IL, and some of the plurality of wiring patterns may be connected to a plurality of via structures TSV.

The plurality of via structures TSV may be formed to have a length sufficient to penetrate through the insulating layer IL as well as the semiconductor substrate SUB, and may be a through silicon via. Each of the plurality of via structures TSV may be connected to a corresponding one of a plurality of upper pads UP on an upper surface of the insulating layer IL, and may be connected to a corresponding one of a plurality of lower pads LP on a lower surface of the semiconductor substrate SUB. For example, each of the plurality of via structures TSV may contact a corresponding upper pad UP on the upper surface of the insulating layer IL and a corresponding lower pad LP on the lower surface of the semiconductor substrate SUB. Although not illustrated, an insulating layer may be formed between the plurality of lower pads LP and the semiconductor substrate SUB so that the plurality of lower pads LP are not in direct contact with the semiconductor substrate SUB.

In an example embodiment illustrated in FIG. 7, a width of each of the plurality of lower pads LP may be greater than a width of each of the plurality of upper pads UP. On the other hand, a first gap P1 between the plurality of lower pads LP may be the same as a second gap P2 between the plurality of upper pads UP. The first gap P1 may be defined as a gap between centers of each of the plurality of adjacent lower pads LP, and the second gap P2 may also be defined as a gap between centers of each of the plurality of adj acent upper pads UP. In the example of FIG. 7, the center of a lower pad LP and an upper pad UP in contact with the same via structure TSV may be aligned in the vertical direction. Accordingly, each of the plurality of via structures TSV may be connected to one of the plurality of upper pads UP and one of the plurality of lower pads LP from above and below.

Next, in an example embodiment illustrated in FIG. 8, a first gap P1 between the plurality of lower pads LP in each of the first memory die MD1 and the second memory die MD2 included in a memory layer 300A may be greater than a second gap P2 between the plurality of upper pads UP. For example, the first gap P1 may be 10 um or more, and the second gap P2 may be 10 um or less.

Accordingly, unlike the example the embodiment illustrated in FIG. 7, each of the plurality of via structures TSV may not extend linearly from the upper surface of the insulating layer IL to the lower surface of the semiconductor substrate SUB. Each of the plurality of via structures TSV may be directly connected to the plurality of lower pads LP disposed on the lower surface of the semiconductor substrate SUB and may be connected through wiring patterns different from the plurality of upper pads UP disposed on the upper surface of the insulating layer IL.

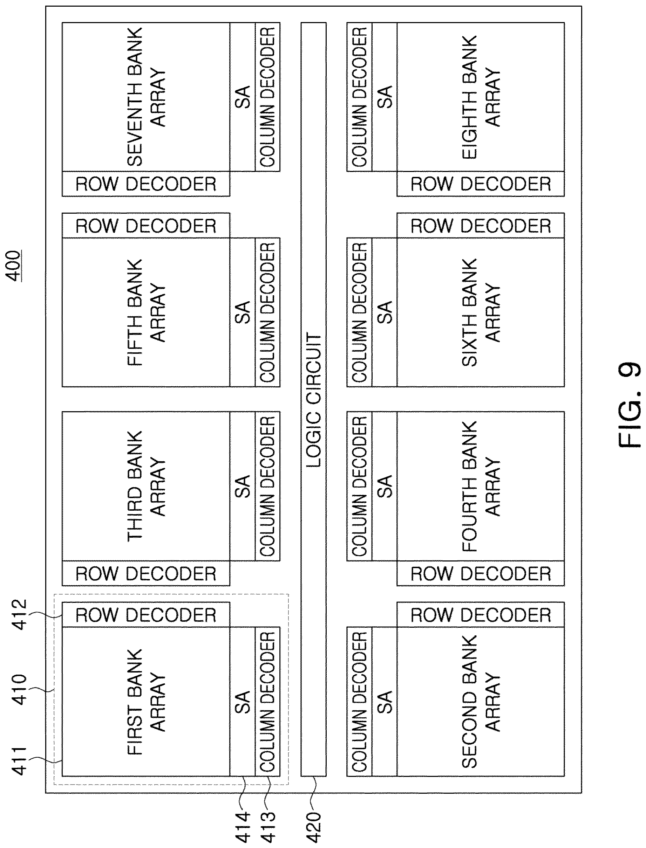

FIG. 9 is a block diagram schematically illustrating a memory die included in a semiconductor package according to an example embodiment of the present disclosure.

Referring to FIG. 9, a memory die 400 according to an example embodiment of the present disclosure may be a dynamic random access memory (DRAM) device. The memory die 400 may include a plurality of memory banks 410 and a logic circuit 420. Each of the plurality of memory banks 410 may include a bank array 411 having a plurality of memory cells, a row decoder 412, a sense amplifier 413, and a column decoder 414.

The plurality of memory banks 410 included in one memory die 400 may share one logic circuit 420. The logic circuit 420 may read data from the memory banks 410 or record data in the memory banks 410. Furthermore, the logic circuit 420 may designate an address to store data or determine an operation mode of the memory die 400. Furthermore, the logic circuit 420 may include an input/output circuit for transmitting data to be stored in the plurality of memory banks 410 and data output by the plurality of memory banks 410, and a plurality of pads connected to the input/output circuit.

The plurality of pads included in the logic circuit 420 may be connected to the plurality of via structures described above. The plurality of upper pads and the plurality of lower pads may be connected on both sides of the plurality of via structures, and the input/output circuit may receive a signal from a buffer die stacked with the memory die 400 through the plurality of via structures, or output the signal to the buffer die.

The bank array 411 may include a memory cell array having a plurality of memory cells. The row decoder 412 may be connected to the memory cell array through a plurality of word lines, and the sense amplifier 413 may be connected to the memory cell array through a plurality of bit lines. Based on a command signal and an address signal received from the buffer die, the logic circuit 420 may perform a write operation to record data in the plurality of memory cells, and a read operation to read data stored in the plurality of memory cells.

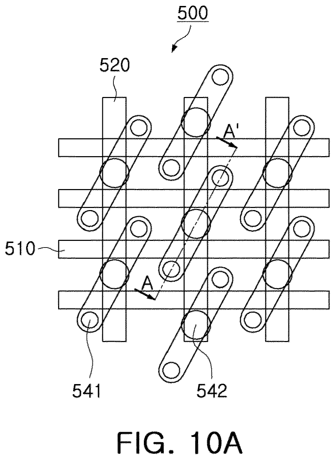

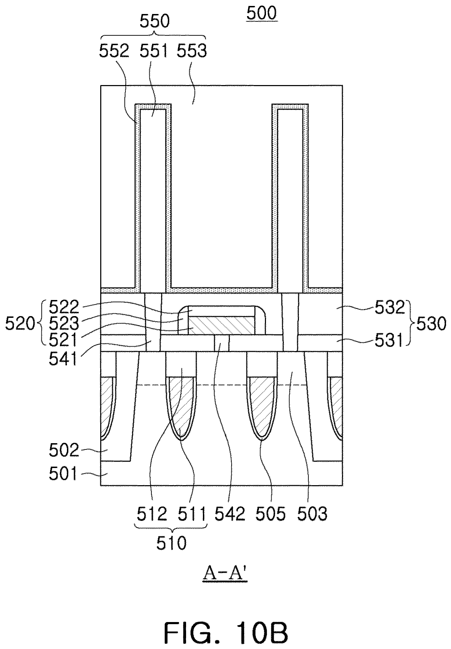

FIGS. 10A and 10B are views schematically illustrating a memory die included in a semiconductor package according to an example embodiment of the present disclosure.

FIG. 10A is a view illustrating a portion of a memory cell array in which a plurality of memory cells are disposed in a memory die according to an example embodiment of the present disclosure, and FIG. 10B may be a cross-sectional view illustrating a cross section in direction A-A' of FIG. 10A. The memory die 500 of FIGS. 10A and 10B may correspond to any of the first or second memory dies MD1 and MD2.

Referring to FIGS. 10A and 10B, a memory die 500 according to an example embodiment of the present disclosure may include a substrate 501, and an element isolation film 502 and an active region 503 may be formed on the substrate 501. Furthermore, a plurality of gate structures 510 may be formed in the form in which they are buried in the substrate 501, and a plurality of bit line structures 520 may be connected to at least some of the active regions 503. An active region 503 not connected to the plurality of bit line structures 520 may be connected to a plurality of capacitor structures 550. As illustrated in FIG. 10A, the plurality of gate structures 510 may intersect with the active region 503 and the plurality of bit line structures 520.

Each of the plurality of gate structures 510 may include a gate electrode layer 511 and a capping layer 512 on the gate electrode layer 511 and contacting the gate electrode layer 511. The gate electrode layer 511 may be formed of a conductive material such as a metal or a metal compound, and the capping layer 512 may be formed of an insulating material such as silicon nitride. A gate insulating layer 505 may be disposed between the gate electrode layer 511 and the substrate 501, and the gate insulating layer 505 may be formed of silicon oxide. The capping layer 512 may contact an upper surface of the gate insulating layer 505.

The active region 503 may be doped with impurities, and may provide a source region and a drain region of a switch element included in the memory cell. Referring to FIG. 10B, the active region 503 disposed between the plurality of gate structures 510 and the element isolation film 502 may be connected to a capacitor structure 550 through a first contact 541. For example, the first contact 541 may contact an upper surface of the active region 503 and a lower surface of the capacitor structure 550. Meanwhile, the active region 503 disposed between a pair of adjacent gate structures 510 may be connected to one of the plurality of bit line structures 520 through the second contact 542. For example, the second contact 542 may contact an upper surface of the active region 503 and a lower surface of the one of the plurality of bit line structures 520.

The plurality of bit line structures 520 may be embedded in an intermediate insulating layer 530 together with the first contact 541 and the second contact 542. The intermediate insulating layer 530 may include a first intermediate insulating layer 531 and a second intermediate insulating layer 532. The second intermediate insulating layer 532 may be on the first intermediate insulating layer 531, and may contact an upper surface of the first intermediate insulating layer 531. The plurality of bit line structures 520 may include a bit line conductive layer 521, a bit line capping layer 522, and a spacer layer 523. The bit line capping layer 522 may contact an upper surface of the bit line conductive layer 521, and the spacer layer 523 may contact opposite side surfaces of the bit line conductive layer 521 and the bit line capping layer 522.

The capacitor structure 550 may be connected to the active region 503 through the first contact 541, and may include a lower electrode layer 551, a dielectric layer 552, and an upper electrode layer 553. The capacitor structure 550 may extend lengthwise in a direction, perpendicular to an upper surface of the substrate 501. The lower electrode layer 551 may have a pillar shape as illustrated in FIG. 10B, or may have a cylinder shape having an empty center.

A semiconductor memory die 500 described with reference to FIGS. 10A and 10B may further include a plurality of wiring patterns for connecting a plurality of memory cells to peripheral circuits such as a row decoder, a sense amplifier and a column decoder. For example, at least some of the plurality of wiring patterns may be disposed on the capacitor structures 550 and may connect a power wiring for supplying a predetermined power voltage to the upper electrode layer 553. Furthermore, some wiring patterns may connect the plurality of gate structures 510 to the row decoder, and other wiring patterns may connect the plurality of bit line structures 520 to the sense amplifier.

At least some of the plurality of wiring patterns may be connected to a plurality of via structures. The plurality of via structures may be formed as a through silicon via penetrating through the semiconductor substrate 501, and may be connected to a plurality of lower pads formed on a lower surface of the semiconductor substrate 501, and a plurality of upper pads formed on an upper surface of an insulating layer formed above the plurality of capacitor structures 550. As described above with reference to FIG. 9, the plurality of via structures may be disposed in a region separated from the plurality of memory cells, for example, a logic circuit region shared by the plurality of memory banks.

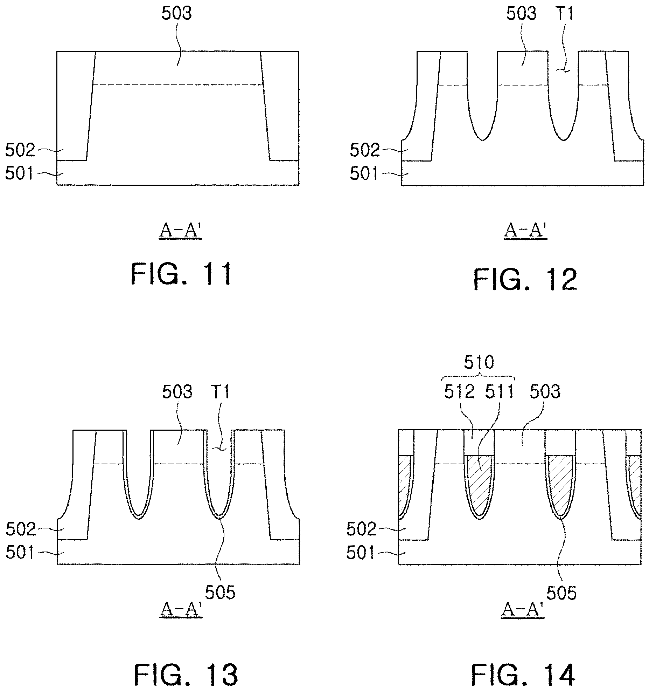

FIGS. 11 to 16 are views illustrating a process of manufacturing a memory die included in a semiconductor package according to an example embodiment of the present disclosure.

FIGS. 11 to 16 may be views illustrating a process of manufacturing the memory die 500 illustrated in FIGS. 10A and 10B. In other words, the manufacturing process described with reference to FIGS. 11 to 16 may be performed at the wafer level.

First, referring to FIG. 11, at least a partial region of the substrate 501 may be removed by etching, and the removed region may be filled with an insulating material, thus forming the element isolation film 502. The element isolation film 502 may be formed over the entire substrate 501. When the element isolation film 502 is formed, impurities may be injected into a region between the element isolation films 502 to form an active region 503. In an example embodiment, the active region 503 may be doped with an N-type impurity.

Next, referring to FIG. 12, first trenches T1 may be formed by etching at least a partial region of the substrate 501 in a region in which the active region 503 is formed. The first trenches T1 may extend lengthwise in a direction in parallel with an upper surface of the substrate 501. As illustrated in FIG. 12, a pair of first trenches T1 may be formed in one active region 503 disposed between a pair of element isolation films 502, and accordingly, one active region 503 may be divided into three regions.

Referring to FIG. 13, a gate insulating layer 505 may be formed in the first trenches T1. The gate insulating layer 505 may be formed of an insulating material such as silicon oxide. Characteristics of the threshold voltage of the switch element included in the memory cell may be determined by a material and a thickness of the gate insulating layer 505.

Next, referring to FIG. 14, a gate structure 510 may be formed in an internal space of the gate insulating layer 505. A gate electrode layer 511 may be formed by filling the first trenches T1 not filled with the gate insulating layer 505, with conductive materials such as tungsten. A capping layer 512 may be formed of an insulating material such as silicon nitride on the gate electrode layer 511.

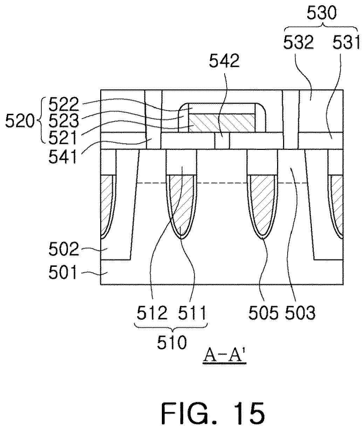

Referring to FIG. 15, a bit line structure 520 may be formed. Before forming the bit line structure 520, a first intermediate insulating layer 531 may be formed on the substrate 501. A partial region of the first intermediate insulating layer 531 may be etched on the active region 503 and the etched region may be filled with a conductive material, thus forming a second contact 542. The second contact 542 may be connected to the active region 503 between a pair of gate structures 510 disposed adjacent to each other.

When the second contact 542 is formed, the bit line structure 520 may be formed. The bit line structure 520 may include a bit line conductive layer 521, a bit line capping layer 522, and a spacer layer 523, and may be embedded in the second intermediate insulating layer 532. When the second intermediate insulating layer 532 is formed, the intermediate insulating layer 530 may be etched and the etched portion may be filled with a conductive material, thus forming the first contact 541.

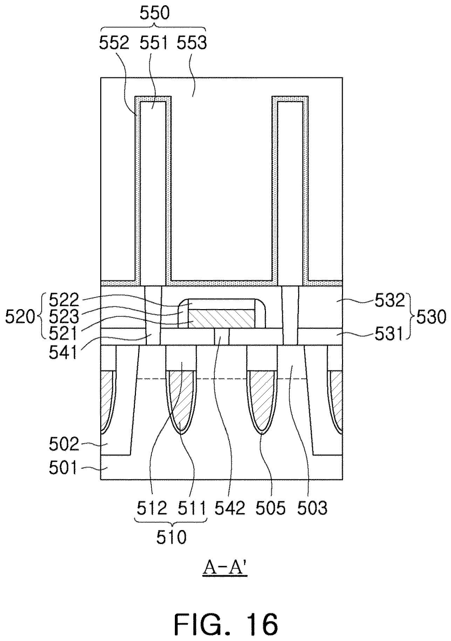

Referring to FIG. 16, a capacitor structure 550 may be formed on the intermediate insulating layer 530. The capacitor structure 550 may include a lower electrode layer 551, a dielectric layer 552, and an upper electrode layer 553. In the capacitor structure 550, the lower electrode layer 551 may have a cylinder structure having an empty center. In this case, the dielectric layer 552 and the upper electrode layer 553 may also be formed in an internal space of the lower electrode layer 551 having the cylinder structure.

When the capacitor structure 550 is formed, a back end of line (BEOL) process for forming a plurality of contacts and a plurality of wiring patterns may be performed. The plurality of contacts and the plurality of wiring patterns connected to the gate structure 510, the bit line structure 520, and the capacitor structure 550 may be formed by the BEOL process.

In the BEOL process, a plurality of pads connected to the plurality of wiring patterns and a plurality of via structures connected to the plurality of pads may be formed. For example, the plurality of via structures may be disposed in a partial region included in one memory die, for example, a region close to a center of the memory die. The plurality of via structures may be connected to the plurality of lower pads disposed on the lower surface of the semiconductor substrate 501, and the plurality of upper pads disposed on an upper surface of an insulating layer formed on an upper surface of the semiconductor substrate 501.

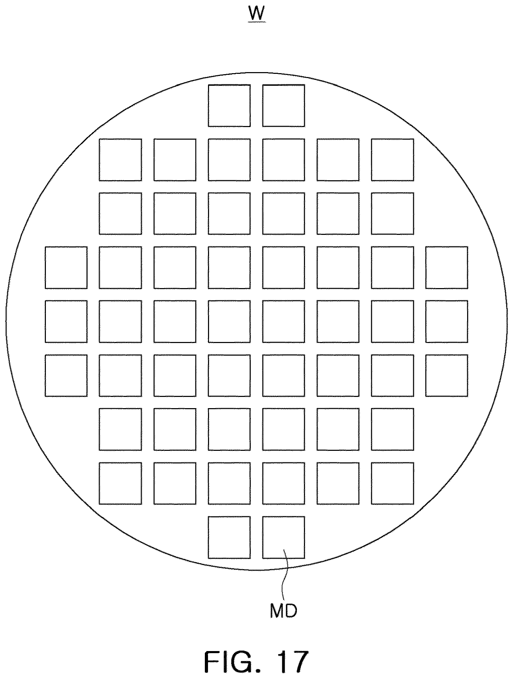

When the plurality of upper pads, the plurality of lower pads, and the plurality of via structures are formed, a process of bonding the memory dies to each other at the wafer level may proceed first before the dicing process of separating the memory dies into chip units. Hereinafter, it will be described with reference to FIGS. 17 to 23.

FIGS. 17 to 23 are views illustrating a process of manufacturing a memory layer included in a semiconductor package according to an example embodiment of the present disclosure.

FIG. 17 may be a view simply illustrating a wafer W after completion of the BEOL process. Referring to FIG. 17, a wafer W may include a plurality of memory dies MD, and the plurality of memory dies MD may be arranged in a horizontal direction and a vertical direction. A space between each of the plurality of memory dies MD may be defined as a separation region for performing the dicing process of separating the plurality of memory dies MD. Each of the plurality of memory dies MD may correspond to one of the first or second memory dies MD1 and MD2.

In an example embodiment of the present disclosure, before performing a dicing process of separating the plurality of memory dies MD from each other, a process of attaching a first wafer W1 and a second wafer W2 having the plurality of memory dies MD formed thereon at a wafer level may be performed ahead. Because the process of attaching the first wafer W1 and the second wafer W2 is performed at the wafer level, each of the first wafer W1 and the second wafer W2 may be in a state in which an FEOL process for forming the plurality of memory dies MD has been completed.

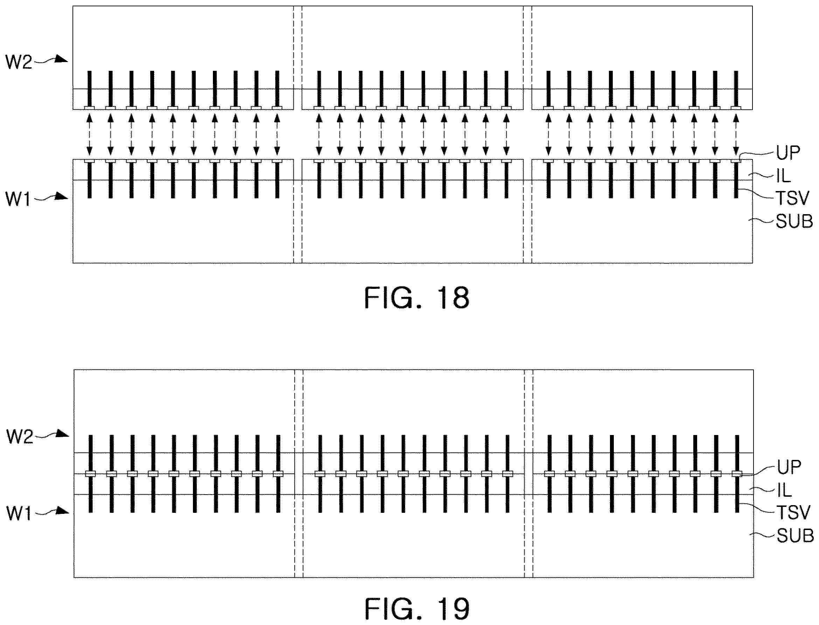

As illustrated in FIG. 18, each of the first wafer W1 and the second wafer W2 may include a semiconductor substrate SUB and an insulating layer IL disposed thereon. A plurality of semiconductor elements may be formed in the semiconductor substrate SUB, and a plurality of contacts and a plurality of wiring patterns, and a plurality of via structures TSV and a plurality of upper pads UP may be formed in the insulating layer IL.

Referring to FIG. 18, the second wafer W2 may be attached on the first wafer W1, and in this case, the second wafer W2 may be attached to the first wafer W1 in a vertically inverted form. Accordingly, the first wafer W1 and the second wafer W2 may be attached to each other in a state in which an upper surface of an insulating layer IL of the second wafer W2 faces an upper surface of an insulating layer IL of the first wafer W1. Referring to FIG. 19, by a process advanced at the wafer level, a plurality of upper pads UP included in the first wafer W1 may be directly attached to a plurality of upper pads UP included in the second wafer W2 without bumps.

For example, the plurality of upper pads UP may be formed of copper (Cu), and the plurality of upper pads UP may be directly connected to each other by a Cu-Cu bonding process. In this case, the insulating layer IL included in the first wafer W1 may also be attached to the insulating layer IL included in the second wafer W2. Accordingly, the first wafer W1 and the second wafer W2 may be attached so that there is little space therebetween. For example, the first wafer W1 may contact the second wafer W2.

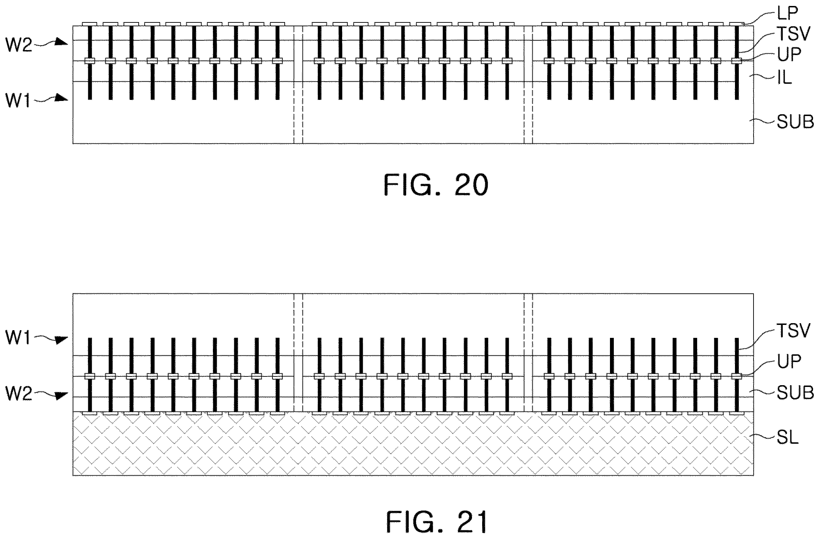

Referring to FIG. 20, in a state in which the first wafer W1 and the second wafer W2 are attached to each other, a process of removing at least a partial region of a semiconductor substrate SUB included in the second wafer W2 may be performed. For example, by performing a chemical mechanical polishing (CMP) process, the at least a partial region of the semiconductor substrate SUB may be removed, and the semiconductor substrate SUB of the second wafer W2 may be removed so as to expose the plurality of via structures TSV included in the second wafer W2. When the plurality of via structures TSV included in the second wafer W2 are exposed, a plurality of lower pads LP may be formed on a lower surface of the semiconductor substrate SUB of the second wafer W2, as illustrated in FIG. 20.

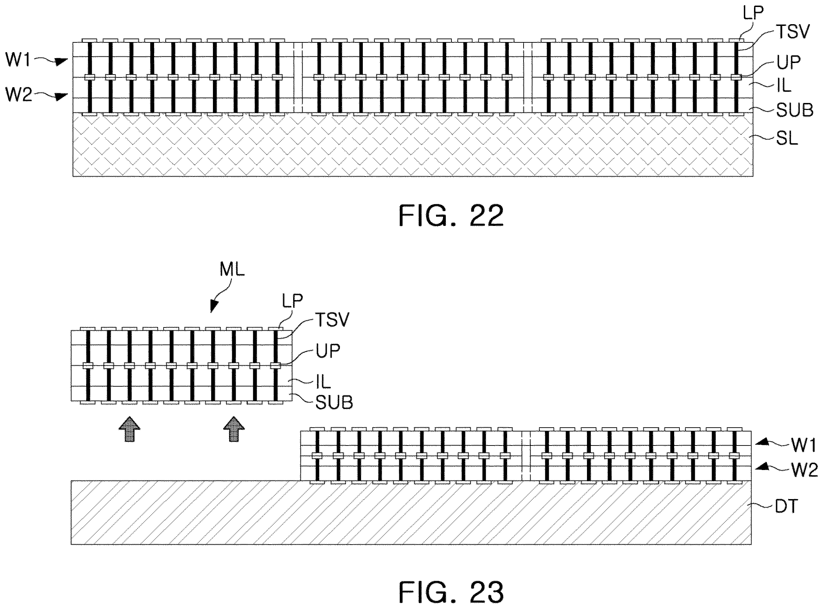

When the plurality of lower pads LP are formed on the second wafer W2, the lower surface of the semiconductor substrate SUB of the second wafer W2 may be attached to a support layer SL and a portion of a semiconductor substrate SUB of the first wafer W1 may be removed. A process of removing a portion of the semiconductor substrate SUB of the first wafer W 1 may be a CMP process as described above, and may proceed until the plurality of via structures TSV included in the first wafer W1 are exposed. When the plurality of via structures TSV of the second wafer W2 are exposed, the plurality of lower pads LP may be formed on the lower surface of the semiconductor substrate SUB of the second wafer W2, as illustrated in FIG. 22.

Then, the support layer SL may be removed, and as illustrated in FIG. 23, the second wafer W2 may be attached to a dicing tape DT. Alternatively, the first wafer W1 may be attached to the dicing tape DT. A plurality of memory layers ML may be obtained by performing the dicing process in a state in which the second wafer W2 is attached to the dicing tape DT. Each of the plurality of memory layers ML includes a first memory die manufactured in the first wafer W1 and a second memory die manufactured in the second wafer W2, and the insulating layer IL and the plurality of upper pads UP included in the first memory die may be directly attached to the insulating layer IL and the plurality of upper pads UP included in the second memory die. Accordingly, when the first memory die and the second memory die are the same chip, each of the plurality of memory layers ML may provide twice as much as storage space as the first memory die.

In the process of manufacturing a semiconductor package, the plurality of memory layers ML separated by the dicing process may be stacked on each other by a process advanced at the chip level. Accordingly, as described above with reference to FIGS. 4 to 6, a semiconductor package in which two or more memory layers ML are stacked on each other may be manufactured. In the process of stacking the plurality of memory layers ML, a plurality of bumps may be used, for example, the plurality of bumps may connect the plurality of lower pads LP included in one memory layer ML to the plurality of lower pads LP included in the other memory layer ML.

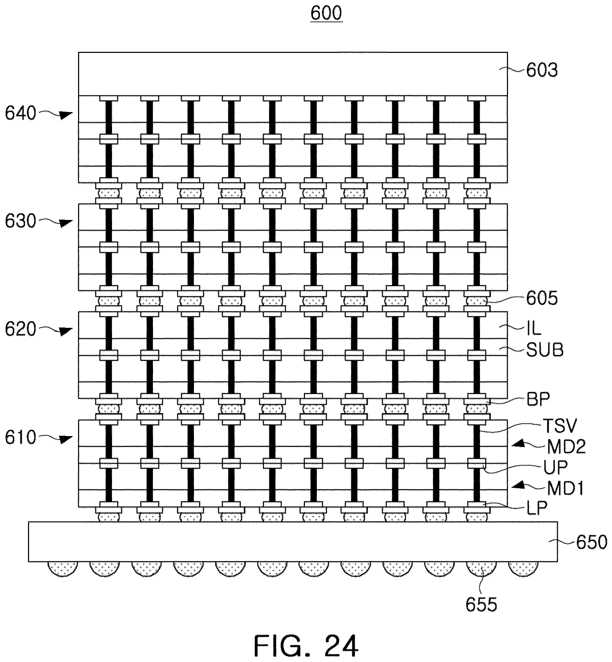

Meanwhile, in an example embodiment described with reference to FIGS. 18 to 23, the first wafer W1 and the second wafer W2 may be attached to each other in a face-to-face (F2F) method, and accordingly, the first memory die and the second memory die may also be attached in the F2F method in each of the plurality of memory layers ML. However, in another example embodiment of the present disclosure, two or more wafers may be attached to each other in a face-to-bottom (F2B) method rather than the F2F method. Hereinafter, it will be described in detail with reference to FIGS. 24 to 26.

FIGS. 24 to 26 are views schematically illustrating a semiconductor package according to example embodiments of the present disclosure.

FIGS. 24 to 26 may be views simply illustrating a cross section of a region in which a plurality of via structures TSV are disposed in each of the semiconductor packages 600, 600A, and 600B according to example embodiments of the present disclosure. Referring to FIG. 24, a semiconductor package 600 according to an example embodiment of the present disclosure may include a plurality of memory layers 610 to 640 and a buffer die 650. The plurality of memory layers 610 to 640 may be stacked on the buffer die 650, and in an example embodiment illustrated in FIG. 24, first to fourth memory layers 610 to 640 may be included. However, according to an example embodiment, a plurality of memory layers 610 to 640 may be mounted on the package substrate and may also be connected to the buffer die 650 mounted on the package substrate by the wiring patterns of the package substrate. In example embodiments, a plurality of bumps 655 may be provided on a lower surface of the buffer die 650.

In an example embodiment illustrated in FIG. 24, each of the first to fourth memory layers 610 to 640 may have a structure in which a first memory die MD1 and a second memory die MD2 are stacked on each other. The second memory die MD2 may be disposed on the first memory die MD1 in each of the first to fourth memory layers 610 to 640.

Each of the first memory die MD1 and the second memory die MD2 may include a semiconductor substrate SUB and an insulating layer IL disposed on the semiconductor substrate SUB. Furthermore, each of the first memory die MD1 and the second memory die MD2 may include a plurality of upper pads UP exposed to an upper surface of the insulating layer IL, a plurality of lower pads LP exposed to the outside from a lower surface of the semiconductor substrate SUB, and a plurality of via structures TSV for connecting the plurality of upper pads UP and the plurality of lower pads LP. In the example embodiment illustrated in FIG. 24, the plurality of upper pads UP may be disposed in a space formed in the insulating layer IL, and the plurality of lower pads LP may be disposed in a space formed in the semiconductor substrate SUB. For example, upper surfaces of the plurality of upper pads UP may be coplanar with an upper surface of the insulating layer IL, and lower surfaces of the plurality of lower pads LP may be coplanar with a lower surface of the semiconductor substrate SUB.

Referring to FIG. 24, the first memory die MD1 and the second memory die MD2 may be attached to each other in the F2B method. In other words, an upper surface of the insulating layer IL of the first memory die MD1 may be attached to a lower surface of the semiconductor substrate SUB of the second memory die MD2. In this process, the plurality of upper pads UP of the first memory die MD1 may be directly attached to the plurality of lower pads LP of the second memory die MD2.

Meanwhile, the plurality of memory layers 610 to 640 may be attached to each other by a plurality of bumps 605 and electrically connected to each other. For example, the plurality of upper pads UP of the second memory die MD2 included in the first memory layer 210 may be attached to the plurality of lower pads LP of the first memory die MD1 included in the second memory layer 220 by the plurality of bumps 605.

In an example embodiment, each of the plurality of upper pads UP and the plurality of lower pads LP may be attached to each other by a Cu-Cu bonding method, and may have such a small area that it is difficult to arrange the plurality of bumps 605. Accordingly, a plurality of bump pads BP may be disposed on the plurality of lower pads LP included in the first memory die MD1 and the plurality of upper pads UP included in the second memory die MD2 in each of the plurality of memory layers 610 to 640. An area of each of the plurality of bump pads BP may be greater than an area of each of the plurality of upper pads UP and the plurality of lower pads LP. The plurality of bump pads BP included in a pair of memory layers disposed adjacent to each other may be physically and electrically connected to each other by the plurality of bumps 605.

In an example embodiment illustrated in FIG. 24, a plurality of semiconductor elements may be disposed between an upper surface of the semiconductor substrate SUB of the first memory die MD1 and an upper surface of the semiconductor substrate SUB of the second memory die MD2 in each of the plurality of memory layers 610 to 640. Furthermore, the plurality of semiconductor elements may be disposed between the upper surface of the semiconductor substrate SUB of the second memory die MD2 included in the first memory layer 610 and the upper surface of the semiconductor substrate SUB of the first memory die MD1 included in the second memory layer 620.

In an example embodiment illustrated in FIG. 24, the semiconductor package 600 includes eight memory dies, and two memory dies MD 1 and MD2 may be included in each of the plurality of memory layers 610 to 640. Meanwhile, a protective layer 603 may be attached to a second memory die MD2 of the uppermost memory layer 640. For example, the plurality of bump pads BP may not be formed on the plurality of upper pads UP included in the second memory die MD2 of the uppermost memory layer 640, and the protective layer 603 may be disposed on the plurality of upper pads UP and the insulating layer IL.

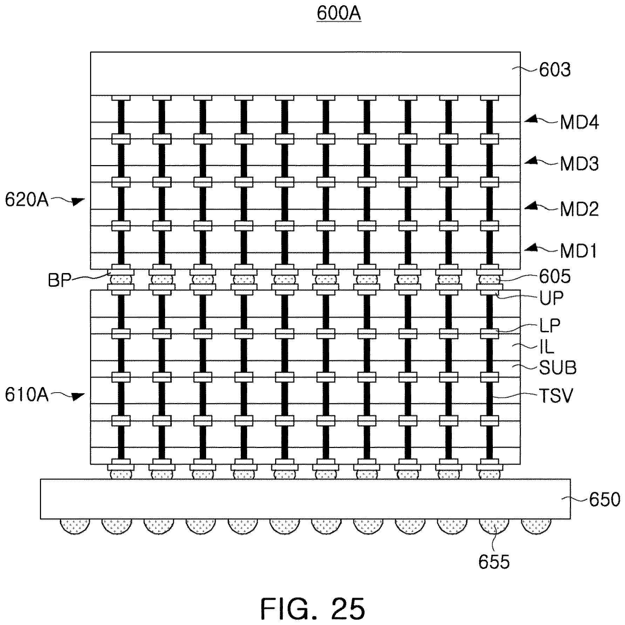

Next, referring to FIG. 25, a semiconductor package 600A according to an example embodiment of the present disclosure may include a plurality of memory layers 610A and 620A and a buffer die 650. Similar to the example embodiment described with reference to FIG. 24, the plurality of memory layers 610A and 620A may be stacked on the buffer die 650.

In an example embodiment illustrated in FIG. 25, each of the plurality of memory layers 610A and 620A may include four memory dies MD1 to MD4. Describing a first memory layer 610A as an example, the first to fourth memory dies MD1 to MD4 may be sequentially stacked. The first to fourth memory dies MD1 to MD4 may have the same structure, and for example, each of the first to fourth memory dies MD1 to MD4 may include a semiconductor substrate SUB and an insulating layer IL disposed on the semiconductor substrate SUB.

Furthermore, each of the first to fourth memory dies MD1 to MD4 may include a plurality of upper pads UP exposed to an upper surface of the insulating layer IL, a plurality of lower pads LP exposed to the outside from a lower surface of the semiconductor substrate SUB, and a plurality of via structures TSV for connecting the plurality of upper pads UP and the plurality of lower pads LP to each other. A plurality of bump pads BP may be attached to the plurality of upper pads UP included in the fourth memory die MD4 of the first memory layer 610A and the plurality of lower pads LP included in the first memory die MD1 of the second memory layer 620A. The first memory layer 610A and the second memory layer 620A may be stacked and electrically connected to each other by the plurality of bumps 605 connected to the plurality of bump pads BP.

Similar to the example embodiment described above with reference to FIG. 24, the first to fourth memory dies MD1 to MD4 may be stacked in the F2B method in each of the first memory layer 610A and the second memory layer 620A. In other words, a lower surface of the semiconductor substrate SUB of the second memory die MD2 may be attached to an upper surface of the insulating layer II, of the first memory die MD1, a lower surface of the semiconductor substrate SUB of the third memory die MD3 may be attached to an upper surface of the insulating layer II, of the second memory die MD2, a lower surface of the semiconductor substrate SUB of the fourth memory die MD3 may be attached to an upper surface of the insulating layer IL of the third memory die MD2.

Meanwhile, at a boundary between a pair of memory dies adjacent to each other among the first to fourth memory dies MD1 to MD4, a plurality of upper pads UP included in one memory die may be directly attached to a plurality of lower pads LP included in the other memory die without bumps. Accordingly, in a structure including eight memory dies as illustrated in the embodiment of FIG. 24, eight memory dies may be stacked using fewer bumps 605. The semiconductor package 600A according to the example embodiment illustrated in FIG. 25 may be implemented with a smaller thickness than that of the semiconductor package 600 according to the example embodiment illustrated in FIG. 24.

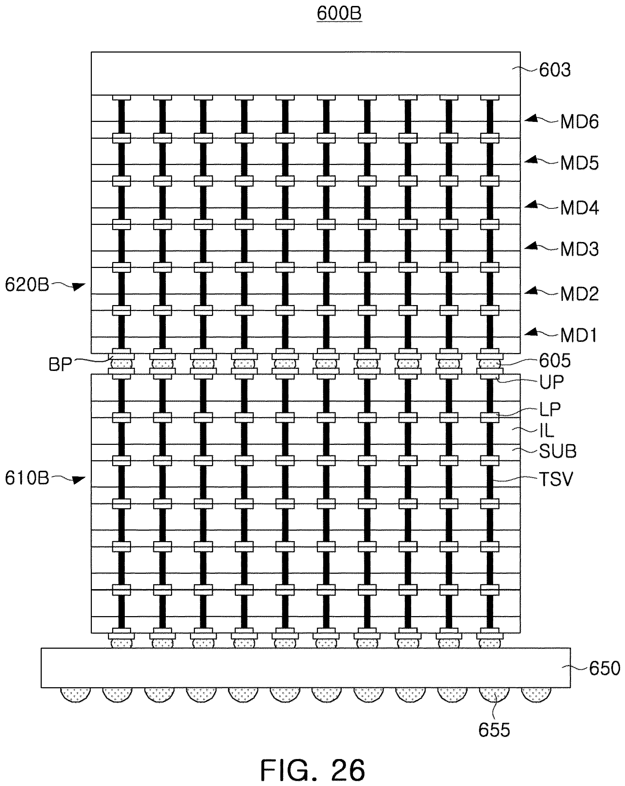

Referring to FIG. 26, a semiconductor package 600B according to an example embodiment of the present disclosure may include a plurality of memory layers 610B and 620B and a buffer die 650. In an example embodiment illustrated in FIG. 26, each of the plurality of memory layers 610B and 620B may include six memory dies MD1 to MD6. In other words, the first to sixth memory dies MD1 to MD6 may be sequentially stacked in each of the plurality of memory layers 610B and 620B. As described above, in the example embodiments described with reference to FIGS. 24 to 26, since the memory dies are stacked in the F2B method, the number of memory dies included in one memory layer may be variously modified.

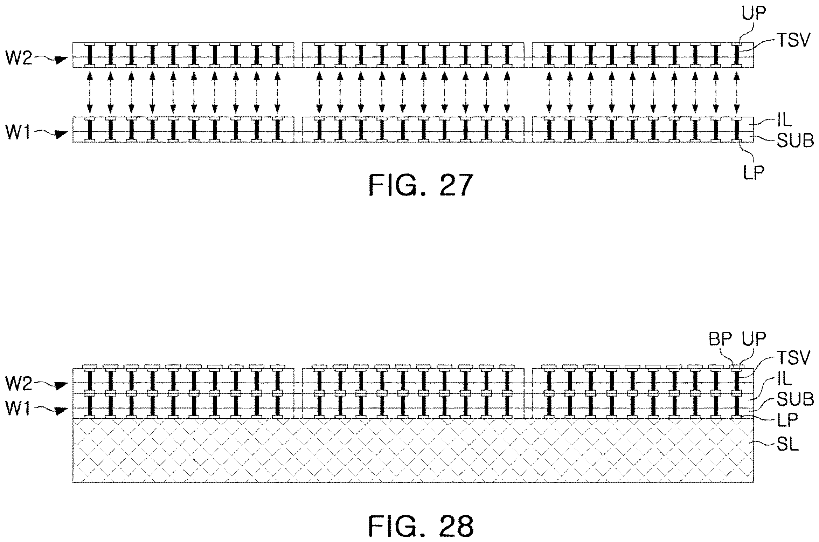

FIGS. 27 to 30 are views illustrating a process of manufacturing a memory layer included in a semiconductor package according to an example embodiment of the present disclosure.

The manufacturing process described with reference to FIGS. 27 to 30 may be the process for manufacturing each of the plurality of memory layers 610 to 640 included in the semiconductor package 600 illustrated in FIG. 24. First, referring to FIG. 27, a first wafer W1 and a second wafer W2 may be attached to each other in the F2B method. For example, an upper surface of an insulating layer IL of the first wafer W1 may be attached to a lower surface of a semiconductor substrate SUB of the second wafer W2, and a plurality of upper pads UP included in the first wafer W1 may be directly attached to a plurality of lower pads LP included in the second wafer W2 without the bumps.

When the first wafer W1 and the second wafer W2 are attached to each other, a process of forming a plurality of bump pads BP on the second wafer W2 may proceed in a state in which the semiconductor substrate SUB of the first wafer W1 is attached to a support layer SL. As illustrated in FIG. 28, the plurality of bump pads BP may be formed on the plurality of upper pads UP included in the second wafer W2.

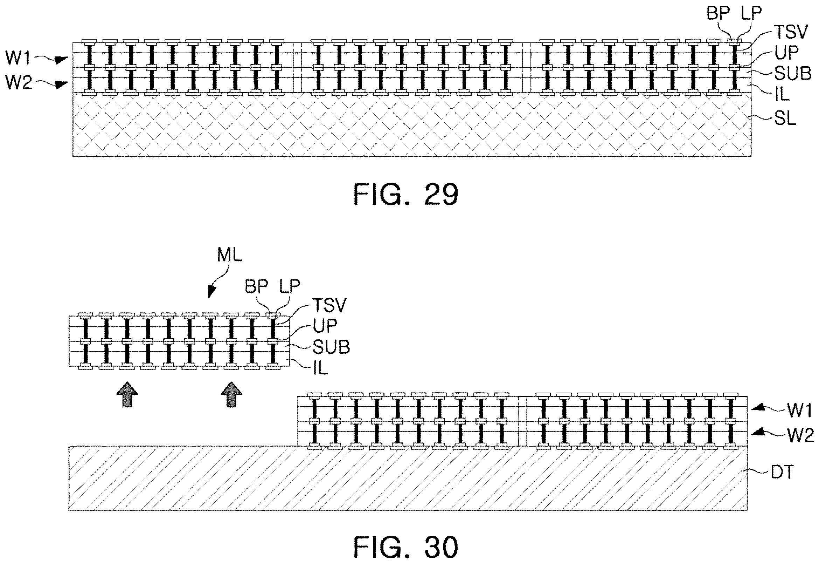

Then, the support layer SL attached to the first wafer W1 may be removed, and as illustrated in FIG. 29, the plurality of bump pads BP may be formed on the first wafer W1 in a state in which the support layer SL is attached to the insulating layer IL of the second wafer W2. When the plurality of bump pads BP are formed on the first wafer W1, the support layer SL may be removed, a dicing tape DT may be attached to the first wafer W1 or the second wafer W2, and then, the dicing process may be performed to obtain a plurality of memory layers ML. In stacking the plurality of memory layers ML, a plurality of bumps attached to the plurality of bump pads BP may be used.

The present disclosure is not limited to the above-described embodiments and the accompanying drawings but is defined by the appended claims. Therefore, those of ordinary skill in the art may make various replacements, modifications, or changes without departing from the scope of the present disclosure defined by the appended claims, and these replacements, modifications, or changes should be construed as being included in the scope of the present disclosure.

## Claims

1. A semiconductor package comprising:
a package substrate;
a buffer die mounted on the package substrate; and
a plurality of memory layers stacked on the buffer die,
wherein each of the plurality of memory layers includes a pair of memory dies,
wherein each memory die of each pair of memory dies includes a semiconductor substrate, a plurality of semiconductor elements formed on the semiconductor substrate, a plurality of via structures penetrating through the semiconductor substrate, a plurality of lower pads formed on a lower surface of the semiconductor substrate and connected to the plurality of via structures, and a plurality of upper pads formed on an upper surface of an insulating layer disposed on the semiconductor substrate and connected to the plurality of via structures, and
wherein the plurality of upper pads included in one memory die of each pair of memory dies are directly attached to the plurality of upper pads included in another memory die of the pair of memory dies.

2. The semiconductor package of claim 1, wherein an upper surface of the insulating layer included in the one memory die of each pair of memory dies is in contact with an upper surface of the insulating layer included in the another memory die of the pair of memory dies.

3. The semiconductor package of claim 1 or 2, wherein, in each memory die of each pair of memory dies, a number of the plurality of upper pads is identical to a number of the plurality of lower pads.

4. The semiconductor package of any preceding, wherein, in each memory die of each pair of memory dies, a gap between the plurality of upper pads is identical to a gap between the plurality of lower pads.

5. The semiconductor package of any of claims 1 to 3, wherein in each memory die of each pair of memory dies, a gap between the plurality of upper pads is less than a gap between the plurality of lower pads.

6. The semiconductor package of any preceding claim,
wherein the plurality of memory layers include a first memory layer stacked on the buffer die and a second memory layer stacked on the first memory layer, and
wherein the plurality of lower pads of the one memory die of each pair of memory dies included in the first memory layer are attached to the plurality of lower pads of the another memory die of the pair of memory dies included in the second memory layer by a plurality of bumps.

7. The semiconductor package of any preceding claim, wherein the plurality of memory layers include first to sixth memory layers sequentially stacked on the buffer die.

8. The semiconductor package of any preceding claim, wherein, among the plurality of memory layers, an uppermost memory layer has a different structure from other memory layers.

9. The semiconductor package of claim 8, wherein the one memory die of each pair of memory dies included in the uppermost memory layer has a different thickness from the another one of the pair of memory dies included in the uppermost memory layer.

10. The semiconductor package of claim 9,
wherein the one memory die of each pair of memory dies included in the uppermost memory layer is an uppermost memory die, and
wherein a thickness of the one memory die of each pair of memory dies included in the uppermost memory layer is greater than a thickness of each of the other memory dies.

11. A semiconductor package comprising:
a package substrate; and
first to third memory dies disposed on the package substrate and sequentially stacked in a first direction, perpendicular to an upper surface of the package substrate,
wherein each of the first to third memory dies includes a semiconductor substrate and a plurality of semiconductor elements formed on an upper surface of the semiconductor substrate, and
wherein, in the first direction, a gap between an upper surface of the semiconductor substrate included in the first memory die and an upper surface of the semiconductor substrate included in the second memory die is different from a gap between the upper surface of the semiconductor substrate included in the second memory die and an upper surface of the semiconductor substrate included in the third memory die.

12. The semiconductor package of claim 11,
wherein the plurality of semiconductor elements included in each of the first memory die and the second memory die are disposed between the upper surface of the semiconductor substrate included in the first memory die and the upper surface of the semiconductor substrate included in the second memory die, and
wherein the plurality of semiconductor elements are not disposed between the upper surface of the semiconductor substrate included in the second memory die and the upper surface of the semiconductor substrate included in the third memory die.

13. The semiconductor package of claim 12,
wherein a plurality of bumps are disposed between the upper surface of the semiconductor substrate included in the second memory die and the upper surface of the semiconductor substrate included in the third memory die, and
wherein the bump is not disposed between the upper surface of the semiconductor substrate included in the first memory die and the upper surface of the semiconductor substrate included in the second memory die.

14. The semiconductor package of claim 13,
wherein each of the first to third memory dies includes a plurality of via structures penetrating through the semiconductor substrate, a plurality of upper pads connected to upper surfaces of the plurality of via structures, and a plurality of lower pads connected to lower surfaces of the plurality of via structures, and
wherein the plurality of upper pads included in the first memory die are in direct contact with the plurality of upper pads included in the second memory die without bumps.

15. The semiconductor package of claim 11,
wherein the plurality of semiconductor elements included in the first memory die are disposed between the upper surface of the semiconductor substrate included in the first memory die and the upper surface of the semiconductor substrate included in the second memory die, and
wherein the plurality of semiconductor elements included in the second memory die are disposed between the upper surface of the semiconductor substrate included in the second memory die and the upper surface of the semiconductor substrate included in the third memory die.
